(19) Europäisches Patentamt / European Patent Office / Office européen des brevets

(11) **EP 4 023 431 B1**

(12) **EUROPEAN PATENT SPECIFICATION**

(45) Date of publication and mention
of the grant of the patent:
**19.02.2025 Bulletin 2025/08**

(21) Application number: **20858182.7**

(22) Date of filing: **25.08.2020**

(51) International Patent Classification (IPC):
*H01B 1/08* (2006.01)     *H01L 31/0747* (2012.01)
*H05B 33/28* (2006.01)     *C23C 14/08* (2006.01)
*C23C 14/34* (2006.01)     *C23C 14/35* (2006.01)
*H01L 31/0216* (2014.01)   *H01L 31/0224* (2006.01)
*H10K 30/82* (2023.01)     *H10K 30/88* (2023.01)
*H10K 85/50* (2023.01)     *H10K 50/84* (2023.01)
*H01J 37/34* (2006.01)     *H10K 30/50* (2023.01)

(52) Cooperative Patent Classification (CPC):
**H01B 1/08; C23C 14/086; C23C 14/3407;
C23C 14/35; H05B 33/28; H10F 10/166;
H10F 77/215; H10F 77/244; H10F 77/311;
H10K 30/82; H10K 30/88; H10K 50/84;
H10K 85/50;** H01J 37/34; H10K 30/50;     (Cont.)

(86) International application number:
**PCT/JP2020/031961**

(87) International publication number:
**WO 2021/039764 (04.03.2021 Gazette 2021/09)**

(54) **MULTILAYER STRUCTURE AND METHOD FOR PRODUCING MULTILAYER STRUCTURE**

MEHRSCHICHTIGE STRUKTUR UND VERFAHREN ZUR HERSTELLUNG EINER MEHRSCHICHTIGEN STRUKTUR

STRUCTURE MULTICOUCHE ET PROCÉDÉ DE PRODUCTION DE STRUCTURE MULTICOUCHE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.08.2019 JP 2019157956**

(43) Date of publication of application:
**06.07.2022 Bulletin 2022/27**

(73) Proprietor: **Keihin Ramtech Co., Ltd.
Kamakura-shi, Kanagawa 248-0035 (JP)**

(72) Inventor: **IWATA, Hiroshi
Kamakura-shi, Kanagawa 248-0035 (JP)**

(74) Representative: **Reichert & Lindner
Partnerschaft Patentanwälte
Prüfeninger Straße 21
93049 Regensburg (DE)**

(56) References cited:
WO-A1-2012/043124     WO-A1-2017/195722
JP-A- 2016 106 440     JP-A- 2017 028 279
JP-A- 2017 152 695     JP-B2- H0 140 884
US-A1- 2016 329 443

• ZHANG D ET AL: "Influence of ITO deposition and post annealing on HIT solar cell structures", ENERGY PROCEDIA, vol. 8, 31 December 2011 (2011-12-31), pages 207 - 213, XP028263067, ISSN: 1876-6102, [retrieved on 20110812], DOI: 10.1016/J.EGYPRO.2011.06.125
• KUN-YI LEE ET AL: "Effect of Oblique-Angle Sputtered ITO Electrode in MAPbI Perovskite Solar Cell Structures", NANOSCALE RESEARCH LETTERS, SPRINGER, US, vol. 12, no. 1, 3 October 2017 (2017-10-03), pages 1 - 6, XP021249644, ISSN: 1931-7573, DOI: 10.1186/S11671-017-2326-Z

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
Y02E 10/549

**Description**

**Technical Field**

The present invention relates to a multilayer structure and a method for producing the multilayer structure.

**Background Art**

Multilayer structures are formed by overlaying a plurality of layers so as to be mutually adjacent. In multilayer structures, each layer has a function such as conductivity, semi-conductivity, or insulation. The functions of the multilayer structure as a whole are achieved by combining the functions of each of the layers. In such multilayer structures, problems sometimes occurred in which a diffusible diffusing component in one layer diffuses into another layer that is adjacent to said one layer, and as a result, the performance of the overall multilayer structure is degraded.

As one example of a multilayer structure, a heterojunction photoelectric conversion device can be mentioned (see, for example, WO 2013/061637 A1). The heterojunction photoelectric conversion device described in WO 2013/061637 A1 has a passivation layer made from hydrogen-terminated amorphous silicon and a transparent conducting layer made of ITO (indium tin oxide), which is provided so as to be adjacent to the passivation layer. With such a heterojunction photoelectric conversion device, for example, in the manufacturing process, hydrogen diffuses from the passivation layer into the transparent conducting layer, and as a result, a problem occurs in that the performance of the photoelectric conversion device (for example, power generation efficiency) is degraded. This problem is not limited to heterojunction photoelectric conversion devices, but rather is a problem that can occur in multilayer structures.

In ZHANG D ET AL, "Influence of ITO deposition and post annealing on HIT solar cell structures", ENERGY PROCEDIA, vol. 8, pages 207-213, XP028263067, ISSN 1876-6102, DOI 10.1016/J.EGYPRO.2011.06.125, three examinations are conducted: influence of ITO sputtering power density on passivation; influence of ITO deposition temperatures; and investigation of post-annealing in air. The deposition of 80-nm thick ITO on both sides of the silicon wafer with an rf-sputtering system is generally described. The methods described do not prevent the degradation of passivation during ITO deposition.

KUN-YI LEE ET AL, "Effect of Oblique-Angle Sputtered ITO Electrode in MAPbI Perovskite Solar Cell Structures", NANOSCALE RESEARCH LETTERS, SPRINGER, US, vol. 12, no. 1, 3 October 2017, pages 1-6, XP021249644, ISSN 1931-7573, DOI 10.1186/S11671-017-2326-Z, reports on the characteristics of MAPbI3 perovskite films on obliquely sputtered ITO/glass substrates that are fabricated with various sputtering times and sputtering angles. The grain size of a MAPbI3 perovskite film increases with the oblique sputtering angle of ITO thin films from 0° to 80°, indicating that the surface properties of the ITO affect the wettability of the PEDOT:PSS thin film and thereby dominates the number of perovskite nucleation sites. The optimal power conversion efficiency (Eff) is achieved 11.3% in a cell with an oblique ITO layer that was prepared using a sputtering angle of 30° for a sputtering time of 15 minutes.

In WO 2019/119869 A1, a first non-water-doped ITO (indium tin oxide) layer is deposited on a phosphorus-doped a-Si:H(n) layer by magnetron sputtering. The flow rate is stabilized at 0.5 sccm, a sputtering power source is turned on, the power density of the power source is 2.1 W/cm 2, and the first water-doped ITO transparent conductive layer is deposited on the first non-water-doped ITO layer by magnetron sputtering. The power source has a power density of 2 W/cm 2, and a second non-water-doped ITO layer is deposited on the first water-doped ITO transparent conductive layer by magnetron sputtering. Hence, the deposition of ITO is performed by means of magnetron sputtering. However, as known from other prior art, e.g. https://www.alcatechnology.com/en/blog/magnetron-sputtering/ from August 05, 2024, in conventional magnetron sputtering, the substrate and the cathode sputtering target are positioned facing each other. As a technical result, the impact on the substrate from sputtering is significant, making it difficult for the generated film to contain a large amount of noble gas.

**Summary of the Invention**

Problems to Be Solved by the Invention

The present invention provides a multilayer structure capable of preventing or suppressing diffusion of a diffusing component from a layer including said diffusing component to a layer adjacent to said layer, and a method for producing the multilayer structure.

Means for Solving the Problems

The present invention adopts the following configuration.

The multilayer structure of the present invention is according to the claims and comprises:

a conducting layer that is conductive and includes a diffusing component capable of diffusing into an adjacent layer; and

a conductive diffusion-prevention layer, provided so as to be adjacent to the conducting layer, including at least one metal or metal oxide, so as be conductive, and including a noble gas, the ratio of the number of atoms of which to the number of atoms of the main metal in the at least one metal or metal oxide being 0.40 or more.

In the multilayer structure of the present invention, the conductive diffusion-prevention layer includes a large quantity of noble gas. Noble gases are chemically stable. A large quantity of noble gas is stably present as monatomic molecules in the conductive diffusion-prevention layer. This can prevent or suppress the diffusion of the diffusing component from the conducting layer to the conductive diffusion-prevention layer. For example, diffusion of a diffusing component in the manufacturing process of a multilayer structure can be prevented or suppressed. As a result, degradation of the performance of the multilayer structure due to the diffusion of the diffusing component can be prevented or suppressed. Since a chemically stable noble gas is used, the influence on the performance of the multilayer structure can be prevented or suppressed.

A main metal refers to the metal (element) having the largest number of atoms among the at least one metal or metal oxide constituting the conductive diffusion-prevention layer. The ratio of the number of atoms of the noble gas to the number of atoms of the main metal in the conductive diffusion-prevention layer is 0.40 or more. Said ratio is preferably 0.50 or more, more preferably 0.60 or more, and further preferably 0.70 or more. By introducing a larger amount of noble gas, the diffusion suppressing effect can be improved. Furthermore, said ratio is preferably 1.0 or less, and more preferably 0.82 or less. Noble gas can be introduced while suppressing or preventing damage to the conductive diffusion-prevention layer and the layer including the diffusing component that is the underlying layer. Note that the conductive diffusion-prevention layer may include a diffusing component of the same type as the diffusing component contained in the conducting layer at the time of manufacture. The diffusion of the diffusing component from the conducting layer to the conductive diffusion-prevention layer can also be prevented or suppressed by adjusting the content of the diffusing component in the conductive diffusion-prevention layer at the time of manufacture. The introduction of a large quantity of noble gas according to the present invention may be applied separately or in combination with the adjustment of the content of the diffusing component in the conductive diffusion-prevention layer. In addition to adjusting the content of the diffusing component in the conductive diffusion-prevention layer, diffusion of the diffusing component from the conducting layer to the conductive diffusion-prevention layer can be prevented or suppressed more effectively by employing the introduction of a large quantity of noble gas into the conductive diffusion-prevention layer. Furthermore, according to the present invention, the diffusion of the diffusing component can be prevented or suppressed by the chemically stable and lowreactivity noble gas. Therefore, even in cases such as those in which it is difficult to make use of adjustment of the content of the diffusing component in the conductive diffusion-prevention layer, diffusion of the diffusing component from the conducting layer to the conductive diffusion-prevention layer can be prevented or suppressed by the present invention.

In the method for producing a multilayer structure of the present invention, the multilayer structure is according to the claims and comprises:

a conducting layer that is conductive and includes a component capable of diffusing into an adjacent layer; and
a conductive diffusion-prevention layer, provided so as to be adjacent to the conducting layer, and including at least one metal or metal oxide, so as to be conductive, and
including a noble gas,
wherein the production method comprises:

a step of preparing the structure in which the conducting layer is formed; and
a step of using a sputtering cathode having a sputtering target, the cross-sectional shape of which is tubular, having a pair of mutually facing long-side portions, and having an erosion surface facing inward and including the at least one metal or metal oxide, placing the structure at a distance from the sputtering target in the axial direction of the sputtering target, performing discharge so as to generate plasma circulating along the inner surface of the sputtering target, and thus sputtering the inner surface of the long-side portions of the sputtering target with ions in the plasma generated by a sputtering gas including the noble gas, and thereby forming the conductive diffusion-prevention layer on the conducting layer of the structure, so as to be adjacent to the conducting layer.

In the method for producing a multilayer structure of the present invention, the conductive diffusion-prevention layer is formed by way of the sputtering cathode described above. The conductive diffusion-prevention layer formed by said sputtering cathode includes a large quantity of noble gas. In addition, with said production method, damage to the conductive diffusion-prevention layer and to the layer including the diffusing component that constitutes the underlying layer, due to sputtering when the noble gas is introduced, can be reduced. Thus, with the method for producing a multilayer structure of the present invention, a large quantity of noble gas can be caused to be present in the conductive diffusion-prevention layer, while damage to the conductive diffusion-prevention layer and the layer including the diffusing component constituting the underlying layer is reduced. This can prevent or suppress the diffusion of the diffusing component from the conducting layer to the conductive diffusion-prevention layer. By way of the method for producing a multilayer structure of the present invention, the conductive diffusion-prevention layer includes a noble gas at, for example, a ratio of the number of atoms thereof with respect to the number of atoms of the main metal in the at least one metal or metal oxide of 0.40 or more. This can more effectively prevent or suppress the diffusion of the diffusing component from the conducting layer to the conductive diffusion-prevention layer. For example, diffusion of a diffusing component in a multilayer structure production process can be more effectively prevented or suppressed. As a result, degradation of the performance of the multilayer structure due to the diffusion of the diffusing component can be more effectively prevented or suppressed. Note that the pair of long-side portions may be constituted by rotary targets. A rotary target has a cylindrical shape and is provided so as to be rotatable around the axis of rotation thereof by a predetermined rotation mechanism. The rotary target is a cylindrical rotary sputtering target. A conventionally known rotation mechanism can, for example, be employed as the rotation mechanism.

Further, in the present invention, the following configuration can be employed for the multilayer structure and the method for producing the multilayer structure described above. The thickness of the conducting layer is not particularly limited, and may be, for example, 100 nm or less, or may be 50 nm or less. The thickness of the conducting layer is not particularly limited, and may be, for example, 1 nm or more, or may be 5 nm or more. The thickness of the conductive diffusion-prevention layer is not particularly limited, and may be, for example, 5 to 100 nm or less.

In one mode of embodiment, the noble gas is of at least one type selected from the group consisting of helium, neon, argon, xenon and krypton. This can more effectively prevent or suppress the diffusion of the diffusing component into the conductive diffusion-prevention layer. In one mode of embodiment, the noble gas is of at least one type selected from the group consisting of helium, neon, and argon. In particular, argon is preferred as the noble gas.

The diffusing component is a nonmetal element having a lower atomic weight than the noble gas. In one mode of embodiment, the diffusing component is an element that is different from the noble gas included in the sputtering gas. The diffusing component is an element having a lower atomic weight than the noble gas. The element having a lower atomic weight than the noble gas is at least one element selected, for example, from the group consisting of hydrogen, lithium (not according to invention), sodium (not according to invention), boron, selenium, phosphorus, magnesium (not according to invention), and beryllium (not according to invention). Further, in one mode of embodiment, the element having an atomic weight lower than the noble gas is at least one element selected, for example, from the group consisting of hydrogen, lithium (not according to invention), sodium (not according to invention), boron, phosphorus, magnesium (not according to invention) and beryllium (not according to invention). The nonmetal element may or may not include a noble gas. The nonmetal element is at least one element selected, for example, from the group consisting of hydrogen, boron, carbon, nitrogen, phosphorus, oxygen, sulfur, selenium, fluorine, chlorine, bromine and iodine. Furthermore, in one mode of embodiment, the diffusing component is an alkali metal element or an alkaline earth metal element having an atomic weight less than the noble gas. The alkali metal element is, for example, at least one element from among lithium and sodium. The alkaline earth metal element is, for example, at least one element from among magnesium and beryllium. The conductive diffusion-prevention layer can more effectively prevent or suppress the diffusion of such diffusing components. In particular, hydrogen is preferable as the diffusing component.

In one mode of embodiment, the multilayer structure is a photoelectric conversion device. The present invention may be suitably applied to a photoelectric conversion device. Degradation of the performance of the photoelectric conversion device can be effectively prevented or suppressed. Photoelectric conversion devices are configured to convert light energy into electrical energy or convert electrical energy into light energy, by the photoelectric effect, for example. The photoelectric effect as referred herein is, for example, the internal photoelectric effect. The photoelectric effect as referred herein may include, for example, the external photoelectric effect in place of, or in addition to, the internal photoelectric effect. The photoelectric effect as referred herein includes, for example, the photovoltaic effect. The photoelectric conversion device is not particularly limited, and examples thereof include a photovoltaic device and an electroluminescence device. The photoelectric conversion device has a photoelectric conversion layer for realizing photoelectric conversion. The photoelectric conversion layer may be made of a single layer or may be composed of a plurality of layers. The conductive diffusion-prevention layer constitutes, for example, an electrode (for example, a transparent conducting layer) of the photoelectric conversion device. The conductive diffusion-prevention layer is, for example, not included in the photoelectric conversion layer. The conducting layer is adjacent to the conductive diffusion-prevention layer. For example, the conducting layer does not constitute an electrode of a photoelectric conversion device. The conducting layer may, for example, be included in the photoelectric conversion layer or may be provided between the photoelectric conversion layer and the electrode without being included in the photoelectric conversion layer.

There are no particular limitations on photoelectric conversion devices in the form of photovoltaic devices (so-called solar cells), and these include, for example, a silicon-based photoelectric conversion devices, compound-based photoelectric conversion devices, and organic-based photoelectric conversion devices. Examples of silicon-based photoelectric conversion devices include single crystal silicon photoelectric conversion devices, polycrystalline silicon photoelectric conversion devices, and thin film-based silicon photoelectric conversion devices. Examples of compound-based photoelectric conversion devices include CIS-based photoelectric conversion devices, CdTe-based photoelectric conversion devices, and group III-V based photoelectric conversion devices. Examples of organic photoelectric conversion devices include dye-sensitized photoelectric conversion devices and organic thin film photoelectric conversion devices. Furthermore, examples of photoelectric conversion devices include heterojunction photoelectric conversion devices and perovskite photoelectric conversion devices. Examples of the electroluminescence devices include organic electroluminescence devices and inorganic electroluminescence devices.

The photoelectric conversion device is preferably a heterojunction photoelectric conversion device, a perovskite photoelectric conversion device, an organic photoelectric conversion device, or an organic electroluminescence light emitting device. The present invention can be more suitably applied to such a photoelectric conversion device. Degradation of the performance of the photoelectric conversion device can be more effectively prevented or suppressed. In organic photoelectric conversion devices, the layers are made of conductive organic substances. The conductive organic substances include, for example, organic compounds including a metal dopant and an organometallic compounds.

The conducting layer may be, for example, a passivation layer including hydrogen as a diffusing component, or may be a layer made of an organic substance. The conductive diffusion-prevention layer can more effectively prevent or suppress the diffusion of the diffusing component from such a conducting layer. As a result, degradation of the performance of the photoelectric conversion device can be more effectively prevented or suppressed. Examples of passivation layers including hydrogen as a diffusing component including an a-Si:H layer, an a-SiC:H layer, an a-SiO:H layer, an a-SiF:H layer, and an a-SiN:H layer. These layers will be described below. The conducting layer includes, for example, dangling bonds terminated by a diffusing component.

The conductive diffusion-prevention layer may be a transparent conducting layer that is transparent and conductive, and may be a layer including at least one element selected from the group consisting of indium, zinc, and tin, as the main metal. Specific examples of the conductive diffusion-prevention layer include, for example, a layer made of at least one kind of material selected from the group consisting of the following materials, a layer including said at least one kind of material as a main component, or a layer substantially made of said at least one kind of material.

indium tin oxide (mixed oxide of indium oxide and tin oxide)
indium zinc oxide (mixed oxide of indium oxide and zinc oxide)
zinc aluminum oxide (mixed oxide of zinc oxide and aluminum oxide)
zinc magnesium oxide (mixed oxide of zinc oxide and magnesium oxide)
zinc boron oxide (mixed oxide of zinc oxide and boron oxide)
zinc beryllium oxide (mixed oxide of zinc oxide and beryllium oxide)
fluorine-doped tin oxide
indium oxide
tin oxide
indium gallium zinc oxide (mixed oxide of indium oxide, gallium oxide, and zinc oxide) Here, main component means that the content ratio (mass%) of said at least one kind of compound is the greatest. Furthermore, this substantially means that an additive component such as a dopant material is allowed. The dopant material will be described below. The present invention can be suitably applied to such a conductive diffusion-prevention layer.

Effects of the Invention

With the multilayer structure of the present invention, it is possible to prevent or suppress the diffusion of a diffusing component from the layer including said diffusing component to a layer adjacent to said layer. Furthermore, with the method for producing a multilayer structure of the present invention, diffusion of said diffusing component from the layer including the diffusing component to the layer adjacent to said layer can be prevented or suppressed, while reducing damage to the conductive diffusion-prevention layer and the layer containing the diffusion component that constitutes the underlying layer.

**Brief Description of Drawings**

FIG. 1 is a cross-sectional view schematically illustrating the configuration of a photoelectric conversion device according to a mode of embodiment.
FIGS. 2 (a) to (d) are cross-sectional views illustrating one example of a procedure in a method for producing a photoelectric conversion device according to a mode of embodiment.

FIGS. 3 (a) and (b) are cross-sectional views illustrating one example of a procedure in a method for producing a photoelectric conversion device according to a mode of embodiment.

FIG. 4 is a vertical cross-sectional view showing a sputtering device used in the method for producing a photoelectric conversion device according to a mode of embodiment.

FIG. 5 is a plan view showing a sputtering cathode in the sputtering device shown in FIG. 4.

FIG. 6 is a vertical cross-sectional view showing the manner in which plasma is generated in the vicinity of the surface of a sputtering target in the sputtering device shown in FIG. 4.

FIG. 7 is a plan view showing the manner in which plasma is generated in the vicinity of the surface of the sputtering target in the sputtering device shown in FIG. 4.

FIG. 8 is a diagram showing one example of detection results for a noble gas and a main metal by way of EPMA.

FIG. 9 (a) is a graph showing the open circuit voltages Voc of the photoelectric conversion devices according to Example 1 and Comparative Example 1, and FIG. 9 (b) is a graph showing the carrier lifetimes of the photoelectric conversion devices according to Example 1 and Comparative Example 1.

FIG. 10 is a cross-sectional view schematically illustrating the configuration of a photoelectric conversion device according to another mode of embodiment.

FIGS. 11 (a) to (c) are cross-sectional views schematically illustrating the configuration of a photoelectric conversion device according to another mode of embodiment.

## Modes for Carrying Out the Invention

### Multilayer Structure

Hereafter, modes for carrying out the invention (hereinafter referred to as "modes of embodiment") will be described with reference to the drawings. Hereafter, a photoelectric conversion device will be described. The photoelectric conversion device is one example of a "multilayer structure". The multilayer structure is not limited to the photoelectric conversion device.

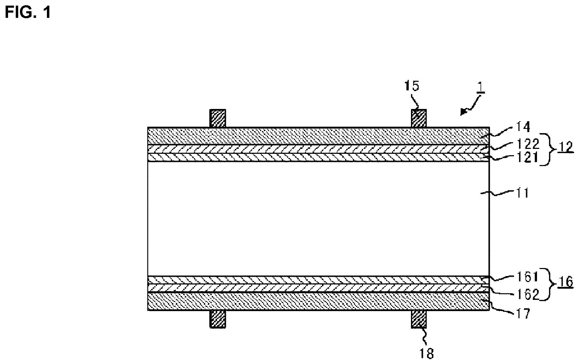

FIG. 1 is a cross-sectional view schematically illustrating the configuration of a photoelectric conversion device according to a mode of embodiment. The photoelectric conversion device 1 comprises a first conductive-type single crystal semiconductor substrate 11, a passivation layer 12 provided so as to be adjacent to the first conductive-type single crystal semiconductor substrate 11, and a first transparent conducting layer 14 provided so as to be adjacent to the passivation layer 12. The passivation layer 12 comprises a substantially intrinsic i-type amorphous hydrogen-containing semiconductor layer 121 provided so as to be adjacent to the first conductive-type single crystal semiconductor substrate 11 and a second conductive-type amorphous hydrogen-containing semiconductor layer 122 provided so as to be adjacent to the i-type amorphous hydrogen-containing semiconductor layer 121. A comb-type first collecting electrode 15 is formed on the first transparent conducting layer 14. Furthermore, the photoelectric conversion device 1 comprises a passivation layer 16 provided so as to be adjacent to the surface opposite to the surface on which the passivation layer 12 is provided, on the first conductive-type single crystal semiconductor substrate 11, and a second transparent conducting layer 17 provided so as to be adjacent to the passivation layer 16. The passivation layer 16 comprises an i-type amorphous semiconductor layer 161 provided so as to be adjacent to the first conductive-type single crystal semiconductor substrate 11 and first conductive-type amorphous semiconductor layer 162 provided so as to be adjacent to the i-type amorphous semiconductor layer 161. The passivation layers 12 and 16 can suppress or prevent carrier recombination. A second collecting electrode 18 is formed on the second transparent conducting layer 17.

The first conductive-type single crystal semiconductor substrate 11 is, for example, an n-type single crystal silicon (hereinafter referred to as c-Si) substrate. Further, the surface of the n-type c-Si substrate may be provided with a recessed and raised structure that reduces the reflection of light incident on the photoelectric conversion device 1 and improves the light confinement effect.

The passivation layer 12 includes an i-type amorphous hydrogen-containing semiconductor layer 121 and a second conductive-type amorphous hydrogen-containing semiconductor layer 122. The passivation layer 12 is conductive. The passivation layer 12 includes, for example, silicon having dangling bonds terminated with hydrogen. The passivation layer 12 is one example of a "conducting layer".

The i-type amorphous hydrogen-containing semiconductor layer 121 is, for example, an a-Si:H layer, an a-SiC:H layer, an a-SiO:H layer, an a-SiF:H layer, or an a-SiN:H layer. Note that the i-type amorphous hydrogen-containing semiconductor layer 121 may consist of a semiconductor material having a single optical bandgap, a semiconductor material whose optical bandgap becomes continuously larger from the first conductive-type single crystal semiconductor substrate 11 side, or a plurality of semiconductor materials stacked so that the optical bandgap becomes larger in steps from the first conductive-type single crystal semiconductor substrate 11 side.

An a-Si:H layer refers to an i-type amorphous hydrogen-containing silicon layer.

An a-SiC:H layer refers to an i-type amorphous hydrogen-containing silicon carbide layer.

An a-SiO:H layer refers to an i-type amorphous hydrogen-containing silicon oxide layer.

An a-SiF:H layer refers to an i-type amorphous hydrogen-containing silicon fluoride layer.

An a-SiN:H layer refers to an i-type amorphous hydrogen-containing silicon nitride layer. Furthermore, the thickness of the i-type amorphous hydrogen-containing semiconductor layer 121 is, for example, 15 nm or less. Note that the i-type, first conductive-type, and second conductive-type amorphous silicon layers used in this mode of embodiment include not only completely amorphous layers but also layers having a partial crystal structure within the layer, such as microcrystalline silicon.

The second conductive-type amorphous hydrogen-containing semiconductor layer 122 may be, for example, a p-type a-Si:H layer, a p-type a-SiC:H layer, a p-type a-SiO:H layer, a p-type a-SiF:H layer or a p-type a-SiN:H layer. Note that, as in the case of the i-type amorphous hydrogen-containing semiconductor layer 121, the second conductive-type amorphous hydrogen-containing semiconductor layer 122 may be made of a semiconductor material having a single optical bandgap, or the optical bandgap may increase continuously or stepwise from the i-type amorphous hydrogen-containing semiconductor layer 121 side. The thickness of the second conductive-type amorphous hydrogen-containing semiconductor layer 122 is, for example, 20 nm or less.

The first transparent conducting layer 14 is one example of a "conductive diffusion-prevention layer". The first transparent conducting layer 14 includes at least one metal or metal oxide. The first transparent conducting layer 14 is made of, for example, at least one metal, a metal oxide, or a combination of these. In the present mode of embodiment, the first transparent conducting layer 14 is made of indium tin oxide (ITO). Indium tin oxide is an inorganic mixture of indium oxide ($In_2O_3$) and tin oxide ($SnO_2$). In the present mode of embodiment, the main metal in the indium tin oxide is indium. Note that the main metal refers to the metal constituting the largest number of atoms among the metals or metal oxides constituting the conductive diffusion-prevention layer. The first transparent conducting layer 14 is not limited to the example described above. The first transparent conducting layer 14 may be made of indium oxide. In this case, the main metal is indium. The first transparent conducting layer 14 may be made of zinc oxide (ZnO). In this case, the main metal is zinc. The first transparent conducting layer 14 may be made of tin oxide. In this case, the main metal is tin. Further, at least one element selected from well-known dopant materials such as aluminum (Al), gallium (Ga), boron (B), and nitrogen (N) may also be added to the conductive diffusion-prevention layer. The first transparent electrode layer 14 may contain a diffusing component of the same type as the diffusing component included in the passivation layer 12 at the time of production.

The first transparent conducting layer 14 includes a noble gas at a ratio of the number of atoms thereof to the number of atoms of the main metal in the metal or metal oxide constituting the first transparent conducting layer 14 of 0.40 or more. The noble gas is of at least one type selected from the group consisting of helium, neon, argon, xenon and krypton. In the present mode of embodiment, the noble gas is argon. The ratio of the number of atoms of the noble gas to the number of atoms of the main metal is preferably 0.50 or more, more preferably 0.60 or more, and further preferably 0.70 or more. The ratio of the number of atoms of the noble gas to the number of atoms of the main metal is preferably 1.0 or less, and more preferably 0.82 or less. The thickness of the first transparent conducting layer 14 is, for example, 5 to 100 nm. The number of atoms can be measured, for example, by way of an electron probe microanalyzer (EPMA).

The comb-type first collecting electrode 15 is, for example, made of at least one kind of element, selected from silver (Ag), Al (aluminum), gold (Au), copper (Cu), nickel (Ni), rhodium (Rh), platinum (Pt), palladium (Pr), chromium (Cr), titanium (Ti), molybdenum (Mo), or the like, or an alloy.

The passivation layer 16 includes an i-type amorphous semiconductor layer 161 and a first conductive-type amorphous semiconductor layer 162. The passivation layer 16 is conductive. The passivation layer 16 includes, for example, silicon having hydrogen-terminated dangling bonds. The passivation layer 16 is one example of a "conducting layer".

The i-type amorphous semiconductor layer 161 is, for example, an i-type a-Si:H layer, an i-type a-SiC:H layer, an i-type a-SiO:H layer, an i-type a-SiF:H layer, or an i-type a-SiN:H layer. The thickness of the i-type amorphous semiconductor layer 161 is, for example, 15 nm or less.

The first conductive-type amorphous semiconductor layer 162 is, for example, an n-type a-Si:H layer, an n-type a-SiC:H layer, an n-type a-SiO:H layer, an n-type a-SiF:H layer, or an n-type a-SiN:H layer. The thickness of the first conductive-type amorphous semiconductor layer 162 is, for example, 20 nm or less.

Note that, as in the case of the i-type amorphous hydrogen-containing semiconductor layer 121, the i-type amorphous semiconductor layer 161 and the first conductive-type amorphous semiconductor layer 162 may be made of a semiconductor material having a single optical bandgap, or the optical bandgap may increase continuously or stepwise toward the first conductive-type single crystal semiconductor substrate 11 side.

The second transparent conducting layer 17 is formed on the back surface of the first conductive-type single crystal semiconductor substrate 11 opposite to the light receiving surface. The second transparent conducting layer 17 is one example of the "conductive diffusion-prevention layer". The second transparent conducting layer 17 can be formed in the same manner as the first transparent conducting layer 14. The second transparent conducting layer 17 may have a surface texture in which recesses and protrusions are formed on the surface. This surface texture can scatter the incident light and enhance the light utilization efficiency in the first conductive-type single crystal semiconductor substrate 11 which is the main generation layer. The first transparent electrode layer 17 may include a diffusing component of the same type as the diffusing component contained in the passivation layer 16 at the time of production.

The second collecting electrode 18 is made of at least one element selected from Ag, Al, Au, Cu, Ni, Rh, Pt, Pr, Cr, Ti, Mo, and the like, or an alloy. note that, although the second collecting electrode 18 is formed as a comb type in FIG. 1, this may also be formed so as to cover the entire surface on the second transparent conducting layer 17.

Note that, in the foregoing description, one example of materials in which the first conductive-type is n-type and the second conductive-type is p-type is shown but, in the materials described above, the first conductive-type may conversely be p-type and the second conductive-type may be n-type.

An overview of the operations in the photoelectric conversion device 1 having such a structure will be described. Note that, here, description will be given in which, in terms of the layers in FIG. 1, the first conductive-type is considered to be n-type, and the second conductive-type is considered to be p-type. In the photoelectric conversion device 1, when light is incident from the first surface side, carriers are generated in the first conductive-type (n-type) single crystal semiconductor substrate 11. The electrons and holes, which are carriers, are separated by an internal electric field formed by the first conductive-type (n-type) single crystal semiconductor substrate 11 and the second conductive-type (p-type) amorphous hydrogen-containing semiconductor layer 122. The electrons move toward the first conductive-type (n-type) single crystal semiconductor substrate 11 and reach the second transparent conducting layer 17 through the passivation layer 16. The holes move toward the second conductive-type (p-type) amorphous hydrogen-containing semiconductor layer 122 and reach the first transparent conducting layer 14. As a result, the first collecting electrode 15 serves as the positive electrode, the second collecting electrode 18 serves as the negative electrode, and electric power is output to the exterior.

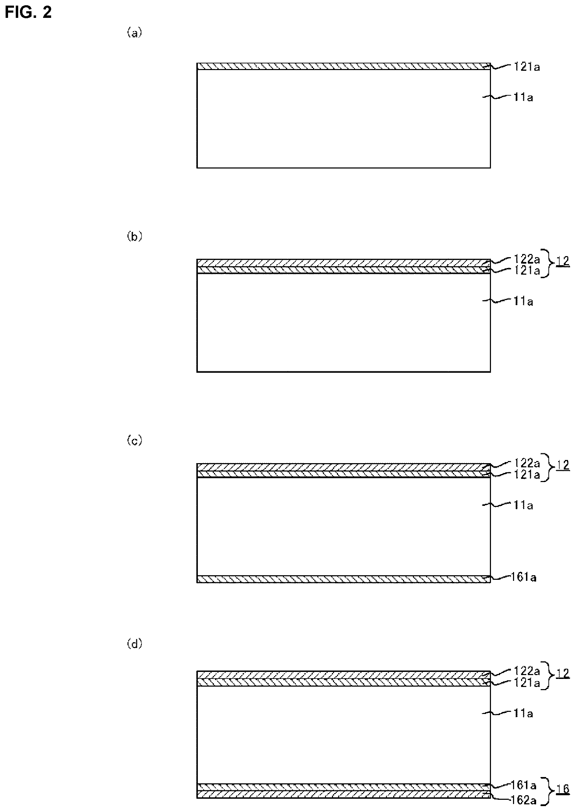

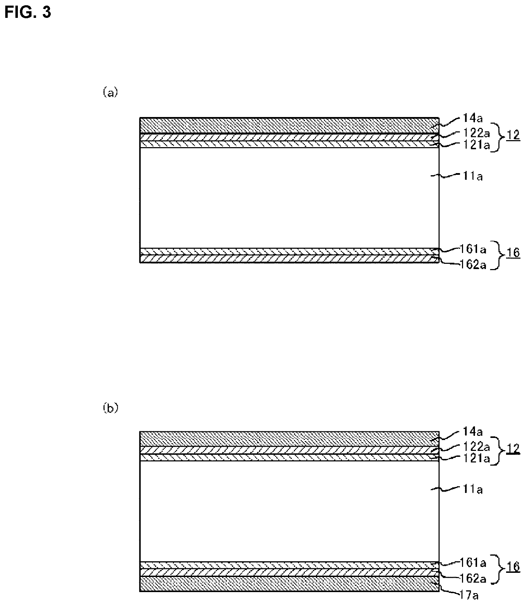

Next, a method for producing the photoelectric conversion device 1 having such a structure will be described. FIG. 2 and FIG. 3 are cross-sectional views schematically illustrating one example of a procedure in a method for producing a photoelectric conversion device according to a mode of embodiment. First, the first conductive-type single crystal semiconductor substrate 11 (n-type c-Si substrate 11a) is prepared. Pyramid-shaped recessed and raised structures having a height of several $\mu$m to several tens of $\mu$m may be formed on both surfaces of the n-type c-Si substrate 11a. The pyramid-shaped recessed and raised structures can be formed, for example, by anisotropic etching using an alkaline solution such as sodium hydroxide (NaOH) or potassium hydroxide (KOH).

Next, cleaning is performed. The n-type c-Si substrate 11a is moved into a first vacuum chamber. Vacuum heating is performed at a substrate temperature of 200°C or lower to remove moisture adhering to the substrate surface. For example, heat treatment is performed at a substrate temperature of 170°C. Then, hydrogen ($H_2$) gas is introduced into the first vacuum chamber. One side of the n-type c-Si substrate 11a is subjected to cleaning by plasma discharge.

Then, as shown in FIG. 2 (a), the i-type a-Si:H layer 121a is formed on one side of the n-type c-Si substrate 11a, as the i-type amorphous hydrogen-containing semiconductor layer 121. The i-type a-Si:H layer 121a is formed, for example, by way of plasma chemical vapor deposition (CVD) under the conditions in which silane ($SiH_4$) gas and $H_2$ gas are introduced into the first vacuum chamber and the substrate temperature is maintained at 170°C.

Subsequently, as shown in FIG. 2 (b), the p-type a-Si:H layer 122a is formed on the i-type a-Si:H layer 121a as the second conductive-type amorphous hydrogen-containing semiconductor layer 122. In this processing, first, the n-type c-Si substrate 11a is moved into a second vacuum chamber. The p-type a-Si:H layer 122a is formed by a plasma CVD method under conditions in which $SiH_4$ gas, $H_2$ gas, and diborane ($B_2H_6$) gas are introduced into the second vacuum chamber. At this time, the substrate temperature is, for example, 170°C or lower. The flow rate of the $B_2H_6$ gas is, for example, approximately 1% with respect to the flow rate of the $SiH_4$ gas. The passivation layer 12 is formed by the i-type a-Si:H layer 121a and the p-type a-Si:H layer 122a.

Then, the n-type c-Si substrate 11a is moved to a third vacuum chamber. $H_2$ gas is introduced into the third vacuum chamber. The substrate temperature is set to 170°C, and the second surface of the n-type c-Si substrate 11a is subjected to cleaning by plasma discharge.

Subsequently, as shown in FIG. 2 (c), the i-type a-Si:H layer 161a is formed on the second surface of the n-type c-Si substrate 11a, as the i-type amorphous semiconductor layer 161. As with i-type a-Si:H layer 121a, the i-type a-Si:H layer 161a is formed by the plasma CVD method under conditions in which $SiH_4$ gas and $H_2$ gas are introduced into the third vacuum chamber and the substrate temperature is maintained at 170°C.

Subsequently, as shown in FIG. 2 (d), an n-type a-Si:H layer 162a is formed on the i-type a-Si:H layer 161a, as the first conductive-type amorphous semiconductor layer 162. In this process, first, the n-type c-Si substrate 11a is moved to a fourth vacuum chamber. The n-type a-Si:H layer 162a is formed by the plasma CVD method under conditions in which $SiH_4$ gas, $H_2$ gas, and phosphine ($PH_3$) gas are introduced into the fourth vacuum chamber and the substrate temperature is maintained at 170°C. The passivation layer 16 is formed by the i-type a-Si:H layer 161a and the n-type a-Si:H layer 162a.

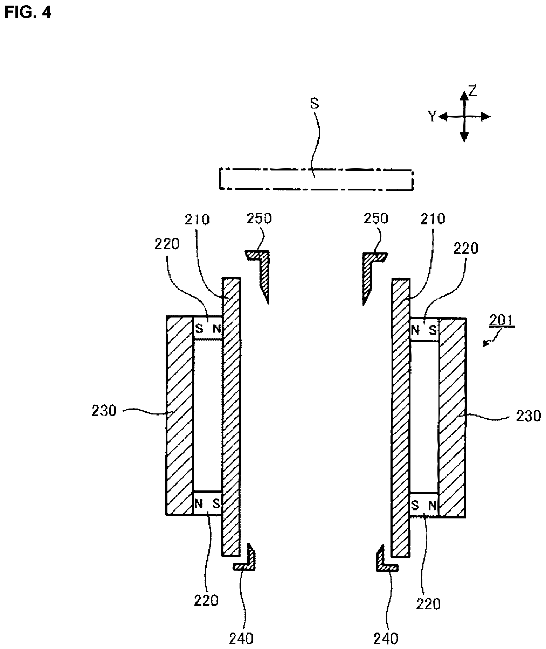

Next, as shown in FIG. 3 (a), the ITO layer 14a is formed on the p-type a-Si:H layer 122a, as the first transparent conducting layer 14. The ITO layer 14a can be formed by a sputtering method using an ITO target. The ITO layer 14a is deposited on the p-type a-Si:H layer 122a by a sputtering method under conditions in which a noble gas, for example, argon (Ar) gas, is introduced into a fifth vacuum chamber and the substrate temperature is approximately room temperature. In addition to the noble gas, $O_2$ gas and/or $H_2$ gas may be introduced. Further, nitrogen ($N_2$) gas may be introduced. Approximately room temperature, as used in this mode of embodiment, means that external heating is not deliberately performed. The ITO layer 14a may be formed by a reactive plasma deposition (RPD) method. The method for forming the ITO layer 14a is not necessarily limited to these methods. The sputtering device used in the sputtering method will be described below with reference to FIG. 4 to FIG. 7. The ITO layer 14a can thereby be caused to include a large quantity of noble gas, as described above. That is to say, by using a sputtering device such as shown in FIG. 4 to FIG. 7, the conductive diffusion-prevention layer (ITO layer 14a) can be formed and a large quantity of noble gas can be included in said layer. It is thereby possible to prevent or suppress diffusion of the diffusing component while reducing damage to said layer and the layer (121a + 122a) including the diffusing component, which is the underlying layer. The conductive diffusion-prevention layer may be produced by a method other than the production method using the aforementioned sputtering device. A conventionally known method such as the aforementioned RPD method can be adopted as such a method. After said layer is formed by another method, a treatment for increasing the noble gas content in said layer may be performed. Examples of such a treatment include an ion implantation method. As a result, a large quantity of noble gas can be introduced into said layer.

Then, as shown in FIG. 3 (b), the ITO layer 17a is formed on the n-type a-Si:H layer 162a, as the second transparent conducting layer 17. In this processing, first, the n-type c-Si substrate 11a is moved to a sixth vacuum chamber. The ITO layer 17a can be produced by various methods such as, for example, a sputtering method, an electron beam deposition method, an atomic layer deposition method, a CVD method, a low pressure CVD method, a MOCVD method, a sol-gel method, a printing method, or a spray method.

Then, the first collecting electrode 15 is formed on the ITO layer 14a. Further, the second collecting electrode 18 is formed on the ITO layer 17a. The first collecting electrode 15 and the second collecting electrode 18 can be produced by applying a conductive paste such as silver paste in a comb shape by a printing method and then baking at a substrate temperature of 200°C for 90 minutes. Furthermore, the second collecting electrode 18 may be composed of a layer made from at least one element selected from Ag, Al, Au, Cu, Ni, Rh, Pt, Pr, Cr, Ti, Mo, or the like, or an alloy, which is highly reflective and conductive. The second collecting electrode 18 may be formed so as to cover the entire surface on the ITO layer 17a. The photoelectric conversion device 1 having the structure shown in FIG. 1 is thus obtained.

Here, a photoelectric conversion device 1 having one semiconductor photoelectric conversion layer has been described as an example, but the present invention is not limited to this. Specifically, the present invention is not limited to a photoelectric conversion device having a heterojunction between crystalline silicon and amorphous silicon but rather can also be applied, for example, to a photoelectric conversion device having a structure in which a transparent conducting layer is formed on a predetermined conductive-type semiconductor layer.

Sputtering Device

Next, the sputtering device used in the sputtering method described above will be described. The sputtering device according to the present mode of embodiment can be used at least for producing a transparent conducting layer. The transparent conducting layer 14 on the light receiving surface side, the transparent conducting layer 17 on the opposite side to the light receiving surface, or both may be formed with said sputtering device.

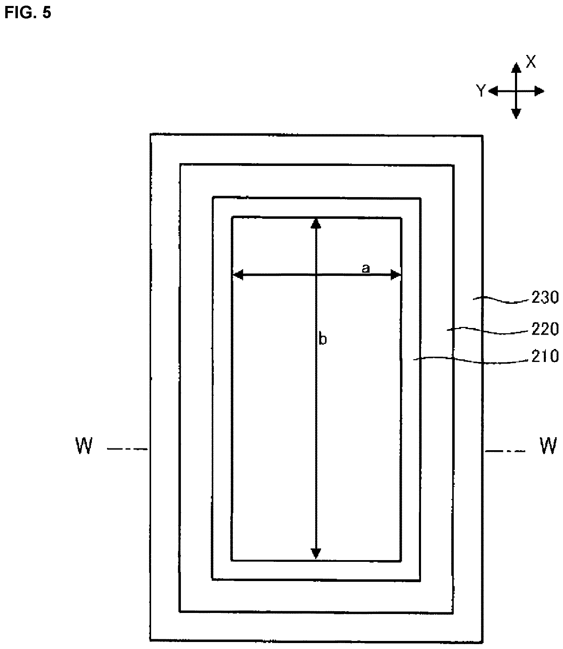

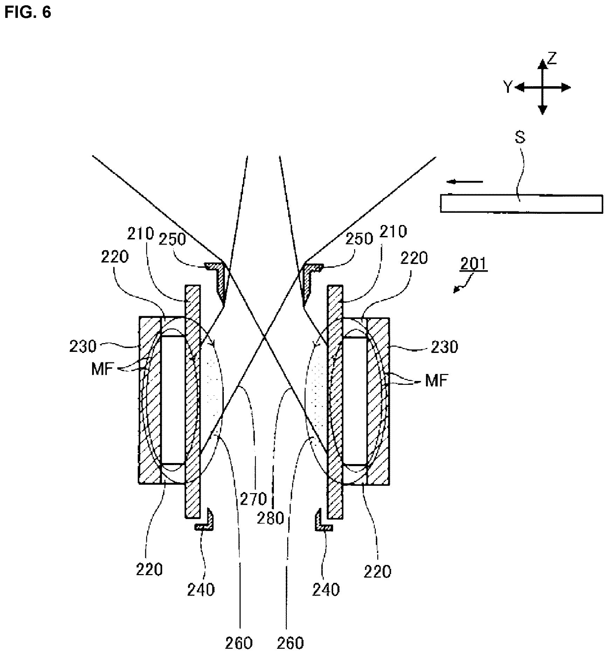

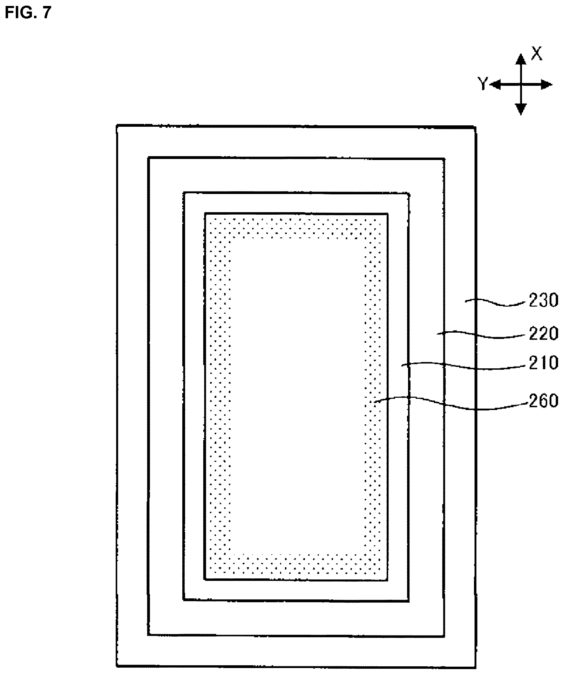

FIG. 4 and FIG. 5 are a vertical cross-sectional view and a plan view showing a sputtering device according to the present mode of embodiment. FIG. 4 and FIG. 5 show configurations near the sputtering cathode and anode provided inside a vacuum vessel of the sputtering device. FIG. 4 is a cross-sectional view taken along a line W-W in FIG. 5. FIG. 6 is a vertical cross-sectional view showing the manner in which plasma is generated in the vicinity of the surface of a sputtering target in the sputtering device shown in FIG. 4. FIG. 7 is a plan view showing the manner in which plasma is generated in the vicinity of the surface of the sputtering target in the sputtering device shown in FIG. 4.

The X direction is the longitudinal direction of the sputtering cathode 201. The Y direction is the lateral direction of the sputtering cathode 201. The Z direction is the axial direction of the sputtering target 210. The X, Y and Z directions are orthogonal to each other. The X direction and the Y direction correspond to radial directions of the sputtering target 210. In the sputtering device provided with the sputtering cathode 201, the X direction is the horizontal direction. The Y direction is the vertical direction. The Z direction is the direction in which the sputtering cathode 201 and a processed object E face each other. However, the Z direction may also be the vertical direction. That is to say, any of sputtering down, side sputtering, and sputtering up can be adopted.

As shown in FIG. 4 and FIG. 5, the sputtering device according to the present mode of embodiment has: a sputtering target 210 having a rectangular tubular shape having a rectangular cross-section and erosion surfaces facing inward, permanent magnets 220 provided outside the sputtering target 210, and a yoke 230 provided outside the permanent magnets 220. The sputtering target 210 is made of the material for forming the transparent conducting layer (14, 17). The sputtering cathode 201 is formed by the sputtering target 210, the permanent magnets 220 and the yoke 230. The sputtering cathode 201 is generally fixed to a vacuum vessel (not shown) in an electrically insulated manner. Further, a magnetic circuit MF (see FIG. 6) is formed by the permanent magnets 220 and the yoke 230. The polarities of the permanent magnets 220 are as shown in FIG. 4, but the polarities may also be respectively the exact opposites. A cooling backing plate (not shown) is preferably provided between the sputtering target 210 and the permanent magnets 220, and a cooling medium (for example, cooling water) flows in a flow path provided inside the backing plate. An anode 240 having an L-shaped cross-section is provided in the vicinity of a rectangular parallelepiped space surrounded by the sputtering target 210 in a manner such that the erosion surface of the sputtering target 210 is exposed. This anode 240 is generally connected to the grounded vacuum vessel. Furthermore, a light blocking shield 250 having an L-shaped cross-section is provided in the vicinity of a rectangular parallelepiped space surrounded by the sputtering target 210 so that the erosion surface of the sputtering target 210 is exposed. The light blocking shield 250 is formed from a conductor, and typically from a metal. The light blocking shield 250 also serves as an anode and is generally connected to the grounded vacuum vessel, in the same manner as the anode 240.

If the distance between the pair of long-side portions of the sputtering target 210 facing each other is **a** and the distance between the pair of short-side portions of the sputtering target 210 facing each other is **b,** as shown in FIG. 5, for example, **b/a** is selected to be 2 or more, and is generally selected to be 40 or less. For example, **a** is generally selected to be 50 mm to 150 mm.

This sputtering device is configured to form a film on a substrate S located at a position separated from said space so as to face the space surrounded by the sputtering target 210. The substrate S is held by a predetermined transfer mechanism (not shown) provided in the sputtering device. Film formation is performed while moving the substrate S with respect to the sputtering target 210 in a direction that transverses the long-side portion of the sputtering target 210 (X direction). The substrate S is not particularly limited, and may be a long film wound on a roll used in a so-called roll-to-roll process, or may be a board.

The vacuum vessel is evacuated to a high vacuum by a vacuum pump, whereafter a noble gas is introduced into the space surrounded by the sputtering target 210, as a sputtering gas. A high voltage, which is generally direct current, required for plasma generation is applied between the anode 240 and the sputtering cathode 201 by a predetermined power source. Generally, the anode 240 is grounded and a negative high voltage (for example, -400 V) is applied to the sputtering cathode 201. As a result, as shown in FIG. 6 and FIG. 7, plasma 260 is generated in the vicinity of the surface of the sputtering target 210, circulating along the inner surface of the sputtering target 210.

The sputtering conditions during film formation are not particularly limited, but in order to increase the noble gas content of the conductive diffusion-prevention layer (transparent conducting layer), the following conditions are, for example, preferably adopted. The noble gas flow rate (for example, argon flow rate) is preferably 50 sccm or more. The noble gas flow rate (for example, argon flow rate) is preferably 500 sccm or less. When oxygen is supplied together with the noble gas, the oxygen flow rate is preferably 2 sccm or more. The oxygen flow rate is preferably 20 sccm or less. The sputtering power is preferably 500 W or more. The sputtering power is preferably 5000 W or less. The direct current discharge voltage (absolute value) is preferably 250 V or more. The direct current discharge voltage (absolute value) is preferably 1000 V or less. Note that a pulse discharge may be used for direct current discharge. The sputtering pressure is preferably 0.1 Pa or more. The sputtering pressure is preferably 1 Pa or less. T-S is preferably 30 mm or more. T-S is preferably 300 mm or less. Note that T-S indicates the distance between the sputtering target 210 and the substrate S. The temperature of the substrate S is preferably 10°C or higher, and more preferably 20°C or higher. The temperature of the substrate S is preferably 70°C or lower, and more preferably 60°C or lower.

As a result of the sputtering target 210 being sputtered by the ions of the noble gas in the plasma 260 orbiting along the inner surface of the sputtering target 210, atoms constituting the sputtering target 210 are ejected from the space surrounded by the sputtering target 210. At this time, atoms are ejected from the portion of the erosion surface of the sputtering target 210 in the vicinity of the plasma 260. However, the atoms ejected from the erosion surface on the inner short-side portion of the sputtering target 210 are not used, for example, for film formation. In order to achieve this, a horizontal shielding plate may be provided above the sputtering target 210 so as to shield both end portions, in the long side direction, of the sputtering target 210, so that atoms ejected from the erosion surfaces of the short-side portions of the sputtering target 210 do not reach the substrate S during film formation. Alternatively, the width b of the sputtering target 210 in the longitudinal direction may be made sufficiently greater than the width of the substrate S, so that atoms ejected from the erosion surface on the short-side portion of the sputtering target 210 do not reach the substrate S during film formation. As shown in FIG. 6, as a result of some of the atoms ejected from the sputtering target 210 being shielded by the light blocking shield 250, sputtered particle fluxes 270, 280 are obtained from the erosion surfaces of the long-side portions of the sputtering target 210. The sputtered particle fluxes 270, 280 have substantially uniform intensity distributions in the longitudinal direction of the sputtering target 210.

When the sputtered particle fluxes 270, 280 have been stably obtained, the film is formed by the sputtered particle fluxes 270, 280, while the substrate S is moved with respect to the sputtering target 210 in the direction that transverses the long-side portion of the sputtering target 210 (X direction). When the substrate S moves towards a position facing the space surrounded by the sputtering target 210, first, the sputtered particle flux 270 is incident on the substrate S, and film formation begins. When the substrate S moves further, and the sputtered particle flux 280 is incident thereon, the sputtered particle flux 280 also contributes to film formation, in addition to the sputtered particle flux 270. As a result, the sputtered particle fluxes 270, 280 are incident on the substrate S and thus form a film. The substrate S is moved further in this manner while film formation is performed. Then, the substrate S is distanced from the space surrounded by the sputtering target 210, moving to a position at which the sputtered particle fluxes 270, 280 are not incident on the substrate S. This completes the film formation.

By using the sputtering cathode 201 described above, the transparent electrode layers 14 and 17, which constitute conductive diffusion-prevention layers, are formed so as to contain a large quantity of noble gas.

Examples

Examples of the photoelectric conversion device having the structure illustrated in the mode of embodiment are shown together with comparative examples.

*Example 1*

An n-type c-Si substrate 11a serving as the first conductive-type single crystal semiconductor substrate 11 was prepared. Next, the n-type c-Si substrate 11a was introduced into a vacuum chamber and heated at 200°C to remove water adhering to the substrate surface. Subsequently, hydrogen gas was introduced into the vacuum chamber, and the surface of the substrate was subjected to cleaning by plasma discharge. Then, the substrate temperature was set to approximately 150°C, $SiH_4$ gas and $H_2$ gas were introduced into the vacuum chamber, and the i-type a-Si:layer 121a was formed by the RF plasma CVD method. Then, $SiH_4$ gas, $H_2$ gas, and $B_2H_6$ gas were introduced to form the p-type a-Si:H layer 122a. Next, an ITO layer 14a was formed on the p-type a-Si:H layer 122a by the sputtering method. The ITO layer 14a is one example of the first transparent conducting layer 14. The ITO layer 14a is comprises $In_2O_3$ to which $SnO_2$ is added. The ITO layer 14a was formed by using a sputtering device having the sputtering cathode 201 shown in FIG. 4 to FIG. 7 with a substrate temperature of approximately room temperature. Subsequently, the i-type a-Si:H layer 161a was formed on the surface on the opposite side of the n-type c-Si substrate 11a by the plasma CVD method. Further, $PH_3$ gas was introduced as a doping gas to form an n-type a-Si:H layer 162a on the i-type a-Si:H layer 161a. Then, an ITO layer 17a was formed on the n-type a-Si:H layer 162a by a sputtering device with the sputtering cathode 201 shown in FIG. 4 to FIG. 7 at a substrate temperature of approximately room temperature. The ITO layer 17a is one example of the second transparent conducting layer 17. Subsequently, Ar gas was introduced into the vacuum chamber, and heat treatment was performed at a substrate temperature of approximately 200°C for approximately 2 hours. Then, the comb-type first collecting electrode 15 and second collecting electrode 18, made of silver paste, were formed in predetermined regions on the upper surfaces of the ITO layers 14a and 17a by a screen printing method. Production of the photoelectric conversion device 1 was thereby completed. Note that the sputtering conditions at the time of forming the ITO layers 14a and 17a were as follows.

argon flow rate: 200 sccm
oxygen flow rate: 6 sccm
sputtering power: 1500 W
direct current discharge voltage (absolute value): 370 V
sputtering pressure: 0.4 Pa
T-S: 100 mm

*Example 2*

A photoelectric conversion device 1 was produced under the same conditions as in Example 1 except that the sputtering pressure at the time of forming the ITO layers 14a and 17a was set to 1.0 Pa.

*Example 3*

A photoelectric conversion device 1 was produced under the same conditions as in Example 1 except that the sputtering pressure at the time of forming the ITO layers 14a and 17a was set to 0.1 Pa.

*Comparative Example 1*

A photoelectric conversion device 1 was produced in the same manner as in Example 1 except that the ITO layers 14a and 17a were formed by a planar magnetron sputtering method. Note that, for the planar magnetron sputtering method, processing was performed under the following conditions.

> argon flow rate: 200 sccm
> oxygen flow rate: 5 sccm
> sputtering power: 1200 W
> direct current discharge voltage (absolute value): 360 V
> sputtering pressure: 0.4 Pa
> T-S: 100 mm

Evaluation Methods

*Ratio of Number of Atoms of Noble Gas/Main Metal*

First, measurement was performed on the ITO layer 14a using a field emission electron probe microanalyzer (EPMA) ("JXA-8500F" made by JEOL Ltd.). The measurement conditions were as follows.

> acceleration voltage: 20 kV
> irradiation current: approximately 0.2 $\mu$m
> measurement area: approximately 10 $\mu$m

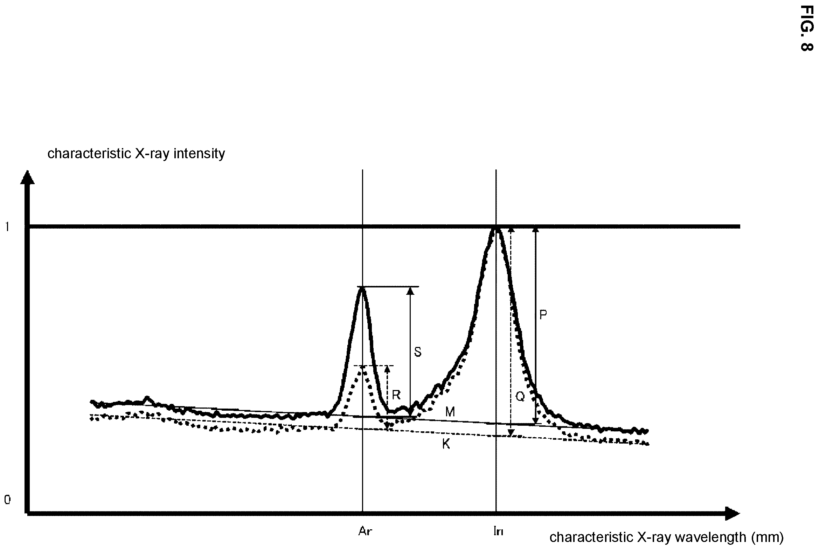

The results obtained were as shown in FIG. 8. FIG. 8 shows one example of results for detection of the noble gas and the main metal by way of EPMA. The vertical axis shows the characteristic X-ray intensity. The characteristic X-ray intensity is indicated so that the peak for the main metal (In) is 1. The horizontal axis indicates the characteristic X-ray wavelength (nm). The data for Example 1 is indicated by the solid line. The data for Comparative Example 1 is indicated by the broken line. M indicates the baseline for the data in Example 1. K indicates the baseline for the data in Comparative Example 1. Note that the baselines M and K shown in FIG. 8 are lines schematically drawn in order to explain the measurement method. P indicates the peak height of the main metal (In) from the baseline M in Example 1. Q indicates the peak height of the main metal (In) from the baseline K in Comparative Example 1. S indicates the peak height of the noble gas (Ar) from the baseline M in Example 1. R indicates the peak height of the noble gas (Ar) from the baseline K in Comparative Example 1. The ratio of the numbers of atoms (Ar/In) in Example 1 was obtained from S/P. The ratio of the numbers of atoms (Ar/In) in Comparative Example 1 was obtained from R/Q. For Examples 2 and 3, the ratio of the numbers of atoms (Ar/In) was obtained by the same method.

*Power Generation Efficiency*

Evaluation of power generation efficiency was performed by measuring the open circuit voltage Voc and the carrier lifetime.
The power generation efficiency is expressed by the following equation (1).

$$\text{Power generation efficiency} = (Jsc \times Voc \times FF\ (\%)) / \text{incident light intensity} \quad (1)$$

(Jsc: short circuit current density, FF: fill factor)
The short circuit current density Jsc is expressed by the following equation (2).

$$Jsc = n_0 \cdot q \cdot \{\exp(qV/kT) - 1\} \quad (2)$$

($n_0$: minority carrier density, q: unit charge, V: potential difference, k: Boltzmann constant, T: temperature)
The minority carrier density $n_0$ is proportional to the carrier lifetime. Therefore, as is clear from equations (1) and (2) above, the power generation efficiency is proportional to the open circuit voltage Voc and the carrier lifetime. Therefore, the power generation efficiency was evaluated by measuring the open circuit voltage Voc and the carrier lifetime.

*Open Circuit Voltage Voc*

The open circuit voltage Voc is the voltage when no current is flowing through the photoelectric conversion device 1. With the photoelectric conversion device 1 in which current is flowing due to irradiation with light, a voltage is applied in the direction opposite to said current, and the voltage is gradually increased. The density of the current flowing when the applied voltage is 0 is the short circuit current density Jsc. The voltage applied when the current stops flowing is the open circuit voltage Voc. Note that the open circuit voltage was measured before film formation by sputtering, immediately after the film formation by sputtering, and immediately after the heat treatment (annealing). In addition, the open circuit voltage was measured in keeping with the number of days elapsed.

*Carrier Lifetime*

The carrier lifetime was measured by the $\mu$-PCD method. When the photoelectric conversion device 1 is pulsed with a laser beam, excess carriers (electron-hole pairs) are generated. The microwave reflectance of the pulsed surface increases as the density of excess carriers increases. Using this phenomenon, the carrier lifetime was measured by measuring the change over time of the microwave reflectance. In this measurement, the carrier lifetime is defined as the time required from the time at which pulse laser irradiation is completed until the microwave reflectance decreases to 1/e. Note that e is Napier's constant. In this measurement, the laser beam was obtained using a semiconductor laser having a wavelength of 904 nm. Further, microwaves were obtained using a single waveguide having a frequency of 10 GHz. Note that the carrier lifetime was measured before film formation by sputtering, immediately after film formation by sputtering, and immediately after heat treatment (annealing). In addition, carrier lifetime was measured in keeping with the number of days elapsed.

Evaluation Results

*Ratio of Number* of *Atoms of Noble Gas/Main Metal*

The ratio of the numbers of atoms (Ar/In) in Example 1 was 0.66. The ratio of the numbers of atoms (Ar/In) in Example 2 was 0.40. The ratio of the numbers of atoms (Ar/In) in Example 3 was 0.82. The ratio of the numbers of atoms (Ar/In) in Comparative Example 1 was 0.30.

*Open Circuit Voltage Voc*

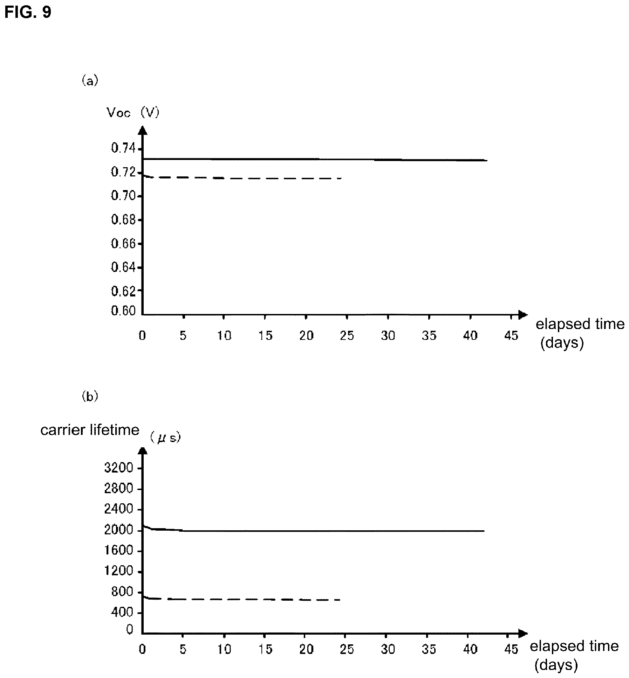

FIG. 9(a) indicates the open circuit voltage Voc and the elapsed time for the photoelectric conversion device according to Example 1 and Comparative Example 1. The solid line indicates the data for Example 1. The broken line indicates the data for Comparative Example 1. A higher open circuit voltage Voc was obtained in Example 1 than in Comparative Example 1. In addition, a high open circuit voltage Voc was maintained for a long period of time in Example 1. In Examples 2 and 3 (not shown), the high open circuit voltage Voc was maintained for a long period of time, as in Example 1.

*Carrier Lifetime*

FIG. 9(b) indicates the carrier lifetime and the number of elapsed days for the photoelectric conversion devices according to Example 1 and Comparative Example 1. The solid line indicates the data for Example 1. The broken line indicates the data for Comparative Example 1. A longer carrier lifetime was obtained in Example 1 than in Comparative Example 1. In addition, a long carrier lifetime was maintained over a long period of time in Example 1. In Examples 2 and 3 (not shown), long carrier lifetimes were maintained for long period of times, as in Example 1.

Furthermore, for Examples 1 to 3 and Comparative Example 1, the open circuit voltage Voc and the carrier lifetime before sputtering, immediately after sputtering, and immediately after annealing are as indicated in the following table.

**[Table 1]**

| | Ratio of noble gas in the film | Photoelectric conversion device performance evaluation items | Before sputtering | After sputtering | After annealing | Amount of change due to sputtering | Amount of change due to annealing |
|---|---|---|---|---|---|---|---|
| Example 1 | 0.66 | open circuit voltage Voc (V) | 0.712 | 0.699 | 0.731 | -0.013 | +0.032 |
| | | carrier lifetime ($\mu$m) | 794 | 447 | 2081 | -347 | +1634 |

(continued)

| | Ratio of noble gas in the film | Photoelectric conversion device performance evaluation items | Before sputtering | After sputtering | After annealing | Amount of change due to sputtering | Amount of change due to annealing |
|---|---|---|---|---|---|---|---|
| Example 2 | 0.40 | open circuit voltage Voc (V) | 0.708 | 0.697 | 0.720 | -0.011 | +0.023 |
| | | carrier lifetime ($\mu$m) | 783 | 442 | 1357 | -341 | +915 |
| Example 3 | 0.82 | open circuit voltage Voc (V) | 0.710 | 0.696 | 0.742 | -0.014 | +0.046 |
| | | carrier lifetime ($\mu$m) | 788 | 436 | 2284 | -352 | +1848 |
| Comparative Example 1 | 0.30 | open circuit voltage Voc (V) | 0.709 | 0.681 | 0.717 | -0.028 | +0.036 |
| | | carrier lifetime ($\mu$m) | 719 | 263 | 711 | -466 | +458 |

As indicated by the "amount of change due to sputtering" (amount of decrease), both the open circuit voltage and the carrier lifetime were reduced by sputtering. The reason for this may be, for example, that the hydrogen-terminated dangling bonds have undergone damage. With respect to both the open circuit voltage and the carrier lifetime, the "amount of change due to sputtering" (amount of decrease) in Examples 1 to 3 was less than the "amount of change due to sputtering" (amount of decrease) in Comparative Example 1. It is considered that this is because large quantities of the noble gas (argon) included in the transparent conducting layer (ITO layer) during formation suppressed diffusion of the diffusing component (hydrogen) from the passivation layer.

As the "value of the change due to annealing" (amount of increase) indicates, both the open circuit voltage and the carrier lifetime were increased by annealing. The reason for this is considered to be, for example, that the dangling bonds are re-terminated by the hydrogen occluded in the layer. With respect to the open circuit voltage, the "change in the value due to annealing" (amount of increase) in Examples 1 and 2 was less than the "change in value due to annealing" (amount of increase) in Comparative Example 1. It is considered that this is because the damage caused by sputtering in Examples 1 and 2 was small, and therefore the amount of increase due to the recovery was also small. On the other hand, the "change in value due to annealing" (amount of increase) in Example 3 was larger than the "change in value due to annealing" (amount of increase) in Comparative Example 1. It is considered that the damage caused by sputtering in Example 3 is small as in Examples 1 and 2, but in Example 3, a large increase was produced by recovery. On the other hand, regarding the carrier lifetime, the "change in value due to annealing" (amount of increase) in Examples 1 and 3 was more than three times the "change in value due to annealing" (amount of increase) in Comparative Example 1. Further, regarding the carrier lifetime, the "change in value due to annealing" (amount of increase) in Example 2 was approximately twice the "change in value due to annealing" (amount of increase) in Comparative Example 1. It is considered that this is because the large quantities of noble gas (argon) included in the transparent conducting layer (ITO layer) formed suppressed the diffusion of the diffusing component (hydrogen) from the passivation layer. In Comparative Example 1 as well, it is considered that hydrogen termination of dangling bonds is produced by annealing, as described above, but hydrogen diffusion also occurs, so that the amount of increase is smaller than that of Examples 1 to 3.

Thus, on the basis of the amount of change in the open circuit voltage and the carrier lifetime due to sputtering and annealing as well, it was confirmed that the transparent conducting layer containing a large quantity of noble gas suppresses or prevents the diffusion of the diffusing component.

As described above, in comparison with the photoelectric conversion device according to Comparative Example 1, the photoelectric conversion devices according to Examples 1 to 3 have higher ratios of the numbers of atoms (Ar/In), were able to achieve higher open circuit voltages Voc and longer carrier lifetimes, and realized excellent power generation efficiency.

In Examples 1 to 3, the sputtering cathode 201 is used when forming the ITO layers 14a and 17a. In the sputtering cathode 201, the sputtering target 210 has erosion surfaces facing each other. In other words, the sputtering target 201 has a pair of long-side portions facing each other. Therefore, the rebounding noble gas (for example, rebounding Ar) may collide with the target multiple times. At each collision, some of the rebounding noble gas is incorporated into the sputtering particles. As a result, sputtering particles including more noble gas are generated, or more sputtering particles containing noble gas are generated. As a result, ITO layers 14a and 17a containing a larger amount of noble gas are formed. On the other hand, with the planar magnetron sputtering method of Comparative Example 1, the sputtering targets do not have portions (erosion surfaces) facing each other. Collisions of the noble gas with the sputtering target therefor usually occur once. As a result, in Comparative Example 1, the content of the noble gas is lower than that in Example 1.

Thus, the noble gas content of the conductive diffusion-prevention layer can be increased by forming the conductive diffusion-prevention layer using the sputtering cathode 201 shown in FIG. 4 to FIG. 7.

For the photoelectric conversion device 1 as in Examples 1 to 3 and Comparative Example 1, the carrier lifetime will be longer with higher passivation layer performance. The performance of the passivation layer depends on the degree of optimization of hydrogen termination of dangling bonds. If an optimized state of hydrogen termination of the dangling bonds in the passivation layer can be maintained due to the layer formed on the passivation layer, the carrier lifetime can be maintained longer. The dangling bond termination state deviates from the optimized state as a result of greater changes or greater propensity to change in conjunction with increased hydrogen diffusion, which reduces carrier lifetime. In the photoelectric conversion device 1 according to Examples 1 to 3, the ratio of the numbers of atoms of the noble gas/main metal in the ITO layers 14a and 17a is high, and the ITO layers 14a and 17a contain more noble gas as compared with Comparative Example 1. The noble gas gives rise to the effect of suppressing the diffusion of hydrogen.

Thus, by increasing the noble gas content of the conductive diffusion-prevention layer, it is possible to suppress or prevent the diffusion of the diffusing component from the conducting layer to the conductive diffusion-prevention layer.

Variants

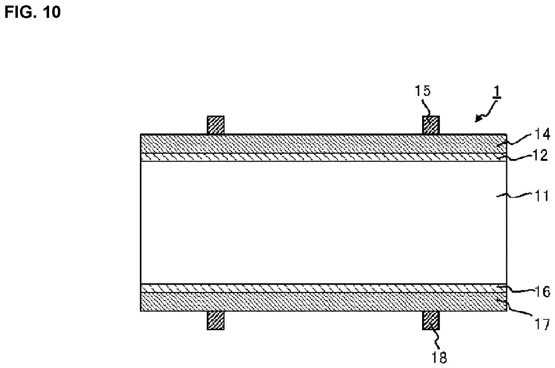

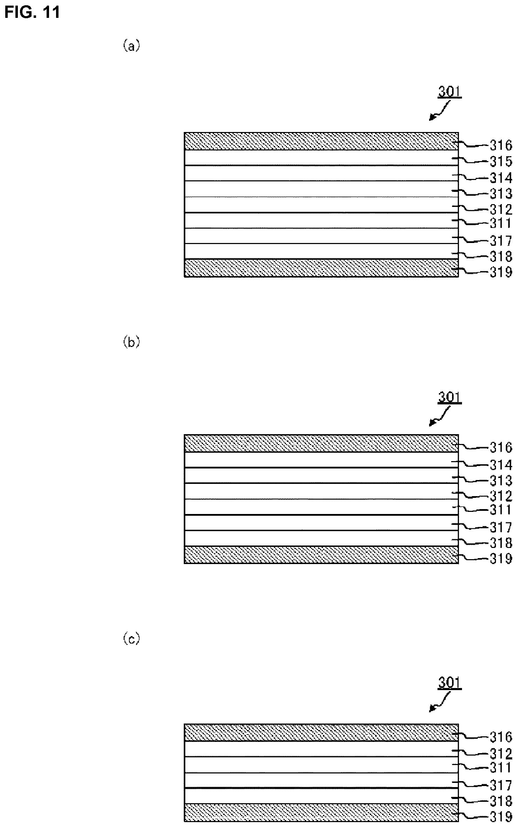

The multilayer structure of the present invention is not limited to the example shown in FIG. 1. Examples of the multilayer structure of the present invention include the photoelectric conversion devices shown in FIG. 10 and FIGS. 11 (a) to (c).

FIG. 10 is a cross-sectional view schematically illustrating the configuration of a photoelectric conversion device according to another mode of embodiment. The multilayer structure 1 shown in FIG. 10 has the same lamination structure as the multilayer structure 1 shown in FIG. 1, except that the passivation layers 12 and 16 are single layers. Here, the differences with respect to the multilayer structure 1 shown in FIG. 1 will be described, and description other than with regard to said differences will be omitted.

A passivation layer 12 is made from an i-type amorphous hydrogen-containing semiconductor layer. The passivation layer 12 is provided between the first conductive-type single crystal semiconductor substrate 11 and the first transparent conducting layer 14 so as to be in contact with both the first conductive-type single crystal semiconductor substrate 11 and the first transparent conducting layer 14. The i-type amorphous hydrogen-containing semiconductor layer can be formed in the same manner as the i-type amorphous hydrogen-containing semiconductor layer 121 described above.

A passivation layer 16 is made from an i-type amorphous semiconductor layer. The passivation layer 16 is provided between the first conductive-type single crystal semiconductor substrate 11 and the second transparent conducting layer 17 so as to be in contact with both the first conductive-type single crystal semiconductor substrate 11 and the second transparent conducting layer 17. The i-type amorphous semiconductor layer can be formed in the same manner as the i-type amorphous semiconductor layer 161 described above.

FIGS. 11 (a) to (c) are cross-sectional views schematically illustrating the configurations of a photoelectric conversion devices according to another mode of embodiment. The photoelectric conversion devices 301 according to each of FIGS. 11 (a) to (c) are an organic electroluminescence devices.

In the photoelectric conversion device 301 shown in FIG. 11 (a), an electron transport layer 312 (ETL), a charge generation layer 313 (CGL), a hole transport layer 314 (HTL) a protective layer 315, and a transparent conducting layer 316 are laminated in this order from the bottom to the top in the figure so that adjacent layers are in contact with each other, on the light receiving surface (upper surface in the figure) of a light emitting layer 311 (EML). A hole transport layer 317 (HTL), a hole injection layer 318 (HIL), and a metal electrode layer 319 are laminated in this order from top to bottom in figure so that adjacent layers are in contact with each other, on the surface of the light emitting layer 311 (EML) opposite to the light receiving surface (lower surface in the figure). The protective layer 315 contains a diffusing component (for example, hydrogen), and the transparent conducting layer 316 includes a large quantity of noble gas as described above. Other than in this regard, known configurations can, for example, be adopted for each of the layers 311 to 319. The protective layer 315 is made of, for example, a conductive organic substance. Conductive organic substances include, for example, organic compounds including a metal dopant, metal organic compounds, and more specifically, organic metal complexes such as, for example, metal phthalocyanines. The same configuration as that of the transparent conducting layers 14 and 17 described above can be adopted for the transparent conducting layer 316. In the photoelectric conversion device 301 shown in FIG. 11 (a), the protective layer 315 is one example of the "conducting layer", and the transparent conducting layer 316 is one example of the "conductive diffusion-prevention layer".

The photoelectric conversion device 301 shown in FIG. 11 (b) is the same as the photoelectric conversion device 301 shown in FIG. 11 (a) except that it does not have the protective layer 315, and thus the differences will be described below, and description other than with regard to the differences will be omitted. The hole transport layer 317 contains a diffusing component (for example, hydrogen), and the transparent electrode layer 316 includes a large quantity of noble gas as described above. In the photoelectric conversion device 301 shown in FIG. 11 (b), the hole transport layer 314 is one example of the "conducting layer", and the transparent conducting layer 316 is one example of the "conductive diffusion-prevention layer".

The photoelectric conversion device 301 shown in FIG. 11 (c) is the same as the photoelectric conversion device 301 shown in FIG. 11 (b) except that it does not have charge generation layer 313 and the hole transport layer 314, and thus the differences will be described below, and description other than with regard to the differences will be omitted. The electron transport layer 312 contains a diffusing component (for example, hydrogen), and the transparent electrode layer 316 includes a large quantity of noble gas as described above. In the photoelectric conversion device 301 shown in FIG. 11 (c), the electron transport layer 312 is one example of the "conducting layer", and the transparent conducting layer 316 is one example of the "conductive diffusion-prevention layer".

The numerical values, materials, structures, shapes, and the like given in the modes of embodiment and examples described above are merely examples, and numerical values, materials, structures, shapes, and the like different from these may be used as necessary.

Explanation of the Reference Numerals

| 1 | photoelectric conversion device |
| 11 | first conductive-type single crystal semiconductor substrate |
| 12 | passivation layer |
| 121 | i-type amorphous hydrogen-containing semiconductor layer |
| 122 | second conductive-type amorphous hydrogen-containing semiconductor layer |
| 14 | first transparent conducting layer |
| 15 | first collecting electrode |
| 16 | passivation layer |
| 161 | i-type amorphous semiconductor layer |
| 162 | first conductive-type amorphous semiconductor layer |
| 17 | second transparent conducting layer |
| 18 | second collecting electrode |

**Claims**

1. A multilayer structure (1, 301) comprising

   a conducting layer (12, 16, 315) that is conductive and includes a diffusing component capable of diffusing into an adjacent layer, the diffusing component being a nonmetal element having a lower atomic weight than a noble gas of a conductive diffusion-prevention layer (14, 17, 316); and
   the conductive diffusion-prevention layer (14, 17, 316), provided so as to be adjacent to the conducting layer (12, 16, 315), including at least one metal or metal oxide, so as be conductive, and including the noble gas, **characterized in that**
   the ratio of the number of atoms of the noble gas to the number of atoms of the main metal in the at least one metal or metal oxide being 0.40 or more.

2. The multilayer structure (1, 301) according to claim 1, wherein the noble gas is of at least one type selected from the group consisting of helium, neon, argon, xenon and krypton.

3. The multilayer structure according to any one of claims 1 to 2, wherein the multilayer structure is a photoelectric conversion device (1, 301).

4. The multilayer structure according to claim 3, wherein the photoelectric conversion device (1, 301) is a heterojunction photoelectric conversion device or a perovskite photoelectric conversion device.

**5.** The multilayer structure according to claim 3, wherein the photoelectric conversion device (1, 301) is an organic photoelectric conversion device or an organic electroluminescence light emitting device.

**6.** The multilayer structure (1, 301) according to any one of claims 3 to 4, wherein the conducting layer (12, 16, 315) is a passivation layer including hydrogen as the diffusing component.

**7.** The multilayer structure (1, 301) according to claim 3 or 5, wherein the conducting layer (12, 16, 315) is made of an organic substance.

**8.** The multilayer structure (1, 301) according to any one of claims 3 to 7, wherein the conductive diffusion-prevention layer (14, 17, 316) is a transparent conducting layer (14, 17, 316) that is transparent and is conductive, and/or wherein the conductive diffusion-prevention layer (14, 17, 316) includes at least one element selected from the group consisting of indium, zinc, and tin as the main metal.

**9.** A method for producing a multilayer structure (1, 301) according to any one of claims 1 to 8, comprising

a step of preparing the structure (1, 301) in which the conducting layer (12, 16, 315) is formed; and
a step of using a sputtering cathode (201) having a sputtering target (210), the cross-sectional shape of which is tubular, having a pair of mutually facing long-side portions, and having an erosion surface facing inward and including the at least one metal or metal oxide, placing the structure at a distance from the sputtering target (210) in the axial direction of the sputtering target (210), performing discharge so as to generate plasma circulating along the inner surface of the sputtering target (210), and thus sputtering the inner surface of the long-side portions of the sputtering target (210) with ions in the plasma generated by a sputtering gas including the noble gas, and thereby forming the conductive diffusion-prevention layer (14, 17, 316) on the conducting layer (12, 16, 315) of the structure (1, 301), so as to be adjacent to the conducting layer (12, 16, 315).

**Patentansprüche**

**1.** Eine mehrschichtige Struktur (1, 301) umfassend

eine leitende Schicht (12, 16, 315), die leitend ist und eine diffundierende Komponente umfasst, die in eine benachbarte Schicht diffundieren kann, wobei die diffundierende Komponente ein Nichtmetallelement mit einem niedrigeren Atomgewicht als ein Edelgas einer leitenden Diffusionsverhinderungsschicht (14, 17, 316) ist; und
die leitende Diffusionsverhinderungsschicht (14, 17, 316), die so vorgesehen ist, dass sie an die leitende Schicht (12, 16, 315) angrenzt, mindestens ein Metall oder Metalloxid enthält, um leitend zu sein, und die das Edelgas enthält,
**dadurch gekennzeichnet, dass**
das Verhältnis der Anzahl der Atome des Edelgases zu der Anzahl der Atome des Hauptmetalls in dem mindestens einen Metall oder Metalloxid 0,40 oder mehr beträgt.

**2.** Die mehrschichtige Struktur (1, 301) nach Anspruch 1, wobei das Edelgas von mindestens einem Typ ist, der aus der Gruppe ausgewählt ist, die aus Helium, Neon, Argon, Xenon und Krypton besteht.

**3.** Die mehrschichtige Struktur nach einem der Ansprüche 1 bis 2, wobei die mehrschichtige Struktur eine photoelektrische Umwandlungsvorrichtung (1, 301) ist.

**4.** Die mehrschichtige Struktur nach Anspruch 3, wobei die photoelektrische Umwandlungsvorrichtung (1, 301) eine photoelektrische Umwandlungsvorrichtung mit Heteroübergang oder eine photoelektrische Umwandlungsvorrichtung mit Perowskiten ist.

**5.** Die mehrschichtige Struktur nach Anspruch 3, wobei die photoelektrische Umwandlungsvorrichtung (1, 301) eine organische photoelektrische Umwandlungsvorrichtung oder eine organische Elektrolumineszenz-Licht emittierende Vorrichtung ist.

**6.** Die mehrschichtige Struktur (1, 301) nach einem der Ansprüche 3 bis 4, wobei die leitende Schicht (12, 16, 315) eine Passivierungsschicht mit Wasserstoff als diffundierender Komponente ist.

7. Die mehrschichtige Struktur (1, 301) nach Anspruch 3 oder 5, wobei die leitende Schicht (12, 16, 315) aus einer organischen Substanz hergestellt ist.

8. Die mehrschichtige Struktur (1, 301) nach einem der Ansprüche 3 bis 7, wobei die leitfähige Diffusionsverhinderungsschicht (14, 17, 316) eine transparente leitfähige Schicht (14, 17, 316) ist, die transparent und leitfähig ist, und/oder wobei die leitfähige Diffusionsverhinderungsschicht (14, 17, 316) mindestens ein Element, ausgewählt aus der Gruppe bestehend aus Indium, Zink und Zinn, als Hauptmetall enthält.

9. Ein Verfahren zur Herstellung einer mehrschichtigen Struktur (1, 301) nach einem der Ansprüche 1 bis 8, umfassend

einen Schritt der Präparierung der Struktur (1, 301), in der die leitende Schicht (12, 16, 315) ausgebildet ist; und einen Schritt der Verwendung einer Sputterkathode (201) mit einem Sputtertarget (210), dessen Querschnittsform röhrenförmig ist, mit einem Paar einander zugewandter Längsseitenabschnitte und mit einer nach innen gerichteten Erosionsfläche, die das mindestens eine Metall oder Metalloxid enthält, wobei die Struktur in einem Abstand von dem Sputtertarget (210) in der axialen Richtung des Sputtertargets (210) angeordnet wird, Durchführen einer Entladung, um ein Plasma zu erzeugen, das entlang der inneren Oberfläche des Sputtertargets (210) zirkuliert, und somit Sputtern der inneren Oberfläche der längsseitigen Abschnitte des Sputtertargets (210) mit Ionen in dem Plasma, das durch ein Sputtergas erzeugt wird, das das Edelgas enthält, und dadurch Bilden der leitenden Diffusionsverhinderungsschicht (14, 17, 316) auf der leitenden Schicht (12, 16, 315) der Struktur (1, 301), so dass sie benachbart zu der leitenden Schicht (12, 16, 315) ist.

**Revendications**

1. Une structure multicouche (1, 301) comprenant

une couche conductrice (12, 16, 315) qui est conductrice et comprend un composant diffusant capable de se diffuser dans une couche adjacente, le composant diffusant étant un élément non métallique ayant un poids atomique inférieur à celui d'un gaz noble d'une couche conductrice de prévention de la diffusion (14, 17, 316) ; et la couche conductrice de prévention de la diffusion (14, 17, 316), disposée de manière à être adjacente à la couche conductrice (12, 16, 315), comprenant au moins un métal ou un oxyde métallique, de manière à être conductrice, et comprenant le gaz noble,
**caractérisé par le fait que**
le rapport entre le nombre d'atomes du gaz noble et le nombre d'atomes du métal principal dans l'au moins un métal ou un oxyde métallique est de 0,40 ou plus.

2. La structure multicouche (1, 301) selon la revendication 1, dans laquelle le gaz noble est d'au moins un type choisi dans le groupe constitué par l'hélium, le néon, l'argon, le xénon et le krypton.

3. La structure multicouche selon l'une des revendications 1 à 2, dans laquelle la structure multicouche est un dispositif de conversion photoélectrique (1, 301).

4. La structure multicouche selon la revendication 3, dans laquelle le dispositif de conversion photoélectrique (1, 301) est un dispositif de conversion photoélectrique à hétérojonction ou un dispositif de conversion photoélectrique à pérovskite.

5. La structure multicouche selon la revendication 3, dans laquelle le dispositif de conversion photoélectrique (1, 301) est un dispositif de conversion photoélectrique organique ou un dispositif d'émission de lumière par électroluminescence organique.

6. La structure multicouche (1, 301) selon l'une quelconque des revendications 3 à 4, dans laquelle la couche conductrice (12, 16, 315) est une couche de passivation comprenant de l'hydrogène comme composant diffusant.

7. La structure multicouche (1, 301) selon la revendication 3 ou 5, dans laquelle la couche conductrice (12, 16, 315) est constituée d'une substance organique.

8. La structure multicouche (1, 301) selon l'une quelconque des revendications 3 à 7, dans laquelle la couche conductrice de prévention de la diffusion (14, 17, 316) est une couche conductrice transparente (14, 17, 316) qui est transparente et conductrice, et/ou
Dans laquelle la couche conductrice de prévention de la diffusion (14, 17, 316) comprend au moins un élément choisi dans le groupe constitué par l'indium, le zinc et l'étain en tant que métal principal.

9. Un procédé de fabrication d'une structure multicouche (1, 301) selon l'une quelconque des revendications 1 à 8, comprenant

une étape de préparation de la structure (1, 301) dans laquelle la couche conductrice (12, 16, 315) est formée ; et une étape d'utilisation d'une cathode de pulvérisation (201) ayant une cible de pulvérisation (210), dont la forme de la section transversale est tubulaire, ayant une paire de parties latérales longues se faisant mutuellement face, et ayant une surface d'érosion tournée vers l'intérieur et comprenant au moins un métal ou un oxyde métallique, en plaçant la structure à une distance de la cible de pulvérisation (210) dans la direction axiale de la cible de pulvérisation (210), effectuer une décharge de manière à générer un plasma circulant le long de la surface intérieure de la cible de pulvérisation (210), et ainsi pulvériser la surface intérieure des parties latérales de la cible de pulvérisation (210) avec des ions dans le plasma généré par un gaz de pulvérisation comprenant le gaz noble, et ainsi former la couche conductrice de prévention de la diffusion (14, 17, 316) sur la couche conductrice (12, 16, 315) de la structure (1, 301), de manière à ce qu'elle soit adjacente à la couche conductrice (12, 16, 315).

FIG. 1

**FIG. 2**

(a)

(b)

(c)

(d)

FIG. 3

(a)

14a
122a ⎫
121a ⎭ 12
11a
161a ⎫
162a ⎭ 16

(b)

14a
122a ⎫
121a ⎭ 12
11a
161a ⎫
162a ⎭ 16
17a

FIG. 4

FIG. 5

**FIG. 6**

**FIG. 7**

**FIG. 8**

FIG. 9

(a)

(b)

FIG. 10

FIG. 11

(a)

(b)

(c)

**EP 4 023 431 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013061637 A1

- WO 2019119869 A1

**Non-patent literature cited in the description**

- **ZHANG D et al.** Influence of ITO deposition and post annealing on HIT solar cell structures. *ENERGY PROCEDIA*, vol. 8, ISSN 1876-6102, 207-213

- Effect of Oblique-Angle Sputtered ITO Electrode in MAPbI Perovskite Solar Cell Structures. **KUN-YI LEE et al.** NANOSCALE RESEARCH LETTERS. SPRINGER, 03 October 2017, vol. 12, 1-6